# EUROPÄISCHE PATENTANMELDUNG

(11) **EP 0 895 448 A2**
(43) Veröffentlichungstag der Anmeldung: **03.02.1999**
(21) Anmeldenummer: 98112504.0
(22) Anmeldetag: 06.07.1998
(51) Int. Cl.: H05K 7/20

(54) **Anordnung zur Belüftung von elektrischen und elektronischen Geräten und Baugruppen**

(30) Priorität: 31.07.1997 DE 19733134
(71) Anmelder: Knürr-Mechanik für die Elektronik AG, D-81829 Munchen (DE)
(72) Erfinder: Heckner, Helmut, 94474 Vilshofen (DE); Rickinger, Thomas, 94424 Arnstorf (DE); Neblich, Josef, 85456 Wartenberg (DE); Spateneder, Werner, 84347 Pfarrkirchen (DE)
(74) Vertreter: Heim, Hans-Karl, Dipl.-Ing.

(57) **Zusammenfassung**

Die Erfindung betrifft eine Anordnung zur Belüftung von elektronischen und elektrischen Geräten, Baugruppen und Bauelementen, welche in Gehäusen, Schränken, Baugruppenträgern angeordnet sind. Die Erfindung ist insbesondere für Lüftereinschübe geeignet, welche mit Axiallüftern bestückt sind und in einem relativ geringen Abstand zu einem zu belüftenden Aufnahmeraum für die elektrischen und elektronischen Geräte etc. angeordnet sind.

Erfindungsgemäß wird zwischen den zu kühlenden Objekten und der Lüftereinheit ein Luftverteilerblech angeordnet, welches ausgestanzte Luftdurchtrittsöffnungen aufweist. Um eine Diffusorwirkung und partielle Richtungsänderung eines Luftvolumenstroms zu erreichen, sind Luftleitflächen mit einer vorgebbaren Neigung und in definierten Bereichen durch einen Stanz- und Biegeprozeß gebildet.

## Beschreibung

Die Erfindung betrifft eine Anordnung zur Belüftung von elektronischen und elektrischen Geräten, Baugruppen und Bauelementen, welche in Gehäusen, Schränken, Gestellen und Baugruppenträgern angeordnet sind.

Die Erfindung ist insbesondere für Lüftereinschübe vorgesehen, welche in Gestellen und Schränken unterhalb oder zwischen Baugruppenträgern und/oder Geräten ausgeordnet werden. Die Erfindung ist jedoch auch für LAN-Schränke und Geräteschränke geeignet, bei denen z.B. ein Luftkanal angeordnet ist und ein Luftvolumenstrom mit Hilfe eines Lüfters, einer Lüfteranordnung, eines Gebläses oder aus einer zentralen Klima- bzw. Belüftungsanlage zugeführt wird, welcher in Abhängigkeit von der notwendigen Kühlung bzw. der Bildung von Wärmenestern in definierte und gezielt ausgerichtete Teilluftströme aufgeteilt werden muß.

Bekannte Lüftereinschübe weisen in der Regel Axiallüfter mit vertikal ausgerichteten Lüfterachsen und oberen Luftaustrittseiten auf. Die Lüftereinschübe sind mit einer Abdeckung versehen, welche im Bereich der Luftaustrittsflächen kreisringförmige Durchbrechungen aufweisen.

Bedingt durch einen relativ großen Nabenbereich treten im Zentrum der Axiallüfter sowie in Bereichen zwischen und außerhalb der Luftaustrittsflächen sogenannte "tote Bereiche" auf, in denen keine oder nur eine geringe Luftströmung vorhanden ist. Diese "toten Bereiche" wirken sich besonders nachteilig in Anordnungen aus, bei denen die Lüftereinschübe zwecks Einsparung von Einbauraum in einem sehr geringen Abstand zu einem Aufnahmeraum mit den zu belüftenden Geräten, Baugruppen und Bauelementen oder auch weiteren zu kühlenden Objekten angeordnet werden. Es kann dann zur Ausbildung von Wärmenestern kommen, welche zu Störungen oder auch zum Ausfall eines Gerätes, einer Baugruppe etc. führen können.

Aus der EP 0 470 926 A1 ist eine Lüftungsanordnung für mit Leiterplatten bestückten Steuerschränken bekannt, bei welcher im Abstand zu einem Aufnahmeraum für parallel angeordnete Leiterplatten wenigstens ein Kühlluft ansaugendes Gebläse vorgesehen ist. Ein Luftverteilerblech, welches im Raster von Führungselementen für die Leiterplattenmindestöffnungen für den Kühlluftstrom des Gebläses angeordnet ist, liegt an den unteren Führungselementen an. Zwischen dem Gebläseaustritt bzw. einer Oberkante eines Lüftereinschubs und dem Luftverteilerblech an der Unterseite der Führungselemente ist ein Stauraum ausgebildet, in dem sich aufgrund der Mindestöffnungen und der darin vorgesehenen Schikanen ein Druck ausbildet, welcher zu einer gleichmäßigen und gerichteten Strömung führen soll. Durch die Höhe des Stauraums, welche etwa der des Lüfters entspricht, wird eine Ausgleichsstrecke definiert. Nachteilig ist die damit verbundene Reduzierung des Einbauraums eines Schrankes, Gestells oder Gehäuses, welche dem ständig steigenden Erfordernis nach einer optimalen Nutzung des Einbauraums entgegensteht.

Aus der DE 34 17 451 C2 ist ein Einschubgehäuse bekannt, welches zur EMV-Abschirmung und Durchlüftung aus zweischaligen Platten aufgebaut ist. Jede Schale ist mit Entlüftungsöffnungen versehen, welche schlitzartig ausgebildet sind und bei zwei benachbarten Schalen nicht miteinander fluchten, wodurch eine wellenförmige Strömung der hindurchströmenden Luft erreicht werden soll. Das Gehäuse besteht aus einem Kunststoff und ist an der Innen- und/oder Außenseite mit einer elektrisch leitenden Schicht versehen.

Ein in der DE-OS 1 908 825 beschriebenes elektrisches Gerät mit thermisch hoch belasteten elektrischen Bauelementen aus plattenartigen Trägern weist Kühlleitungen zwischen den Bauelementen auf, die derart an den Trägerplatten befestigt sind, daß ihre schlitzartigen Austrittsöffnungen auf die Bauelementen gerichtet sind.

Aus der US-PS 4 214 706 ist ein Kühlsystem für Geräteschränke und darin angeordnete Leiterplatten und Baugruppen bekannt, welches eine Belüftungskammer mit einem rechteckigen Querschnitt aufweist. Die Außenwände der Belüftungskammer, welche zu den Leiterplatten und elektrischen Baugruppen gerichtet sind, weisen Längsöffnungen auf. Um einen gleichmäßigen Druck in der mit einem stirnseitig angeordneten Gebläse verbundenen Belüftungskammer zu erreichen, ist eine Trennwand mit Rundlöchern vorgesehen, durch welche zwei Teilkammern gebildet werden.

Der Erfindung liegt die **Aufgabe** zugrunde, eine Anordnung zur Belüftung von Objekten, insbesondere von elektrischen und elektronischen Geräten, Baugruppen und Bauteilen in Aufnahmeräumen von Schränken, Behältern, Baugruppenträgern und dergleichen zu schaffen, welche bei einer raumsparenden Anordnung eine wirkungsvolle Belüftung in vorgebbaren Bereichen eines Aufnahmeraums und sowohl eine gerichtete Luftströmung als auch eine nahezu gleichmäße Belüftung z.B. über einen Einschubquerschnitt ermöglicht.

Erfindungsgemäß weist eine Anordnung zur Belüftung elektrischer und elektronischer Geräte, Baugruppen und Bauelemente in einem Aufnahmeraum eines Gehäuses, Schrankes oder Baugruppenträgers ein Luftverteilerblech mit Luftdurchtrittsöffnungen und Luftleitflächen vor den zu belüftenden elektrischen und elektronischen Geräten, Baugruppen und Bauelementen auf, welches über nahezu die gesamte Fläche des Aufnahmeraums bzw. einer Lüftereinheit reicht und an dem oder den Axiallüftern angeordnet ist, insbesondere aufliegt, wobei die Luftdurchtrittsöffnungen und Luftleitflächen in einer der Ausbildung und Anordnung der Axiallüfter angepaßten Weise angeordnet und ausgebildet sind und eine Belüftung über die gesamte Fläche des Luftleitblechs bzw. Aufnahmeraums gewährleisten.

Ein Grundgedanke der Erfindung kann darin gesehen werden, in einem Luftvolumenstrom einen platten- oder blechartigen Luftverteiler ohne einen Stauraum anzuordnen. Als Luftvolumenstrom wird in diesem Zusammenhang das von einem oder mehreren Lüftern, Gebläse etc. erzeugte Luftvolumen verstanden, welches den zu belüftenden und z.B. in einem Aufnahmeraum angeordneten Objekten zugeführt wird.

Das Luftverteilerblech ist derart ausgebildet, daß der Luftvolumenstrom wenigstens partiell einer Richtungsänderung unterworfen wird. Indem gezielt und einstellbar wenigstens Teilluftströme umgelenkt werden, kann eine gleichmässige Luftverteilung über eine Fläche und/oder eine verstärkte oder auch gedrosselte Belüftung in vorgebbaren Bereichen eingestellt werden.

Zweckmäßigerweise weist das Luftverteilerblech Luftdurchtrittsöffnungen auf, welche derart ausgebildet sind, daß wahlweise Luftleitflächen ausgebildet werden können. Die Luftleitflächen werden in vorgebbaren Bereichen des Luftverteilers und ein- und/oder beidseitig am Luftverteiler ausgebildet, um eine Richtungsänderung zumindest partieller Luftströme und eine Kühlung definierte Bereiche und Objekte zu bewirken. Zu diesem Zweck sind Luftleitflächen an abgewinkelten oder schräg zur Austrittsrichtung des Luftvolumenstroms angeordneten Bereichen, bevorzugt an Stanzbereichen, welche nachfolgend auch als Stanzungen bezeichnet werden, ausgebildet.

Es ist besonders vorteilhaft, daß als Luftverteiler ein Flachmaterial, insbesondere ein Stahlblech, eingesetzt werden kann, in welchem die Luftdurchtrittsöffnungen mit und ohne Luftleitflächen in einem Stanzprozeß hergestellt werden können. Die Fertigung eines derartigen Luftverteilerbleches ist besonders rationell zu gestalten und mit relativ niedrigen Kosten verbunden.

Besonders vorteilhaft ist die Möglichkeit, daß die Luftdurchtrittsöffnungen als Ausstanzungen mit unterschiedlichen Geometrien und Größen, bevorzugt jedoch als Schlitze oder als Langlöcher, hergestellt werden können.

Da die Luftleitflächen ebenfalls zunächst durch eine Stanzung, jedoch mit wenigstens einer punktuellen oder flächigen Verbindung, hergestellt werden, ist nach dem Stanzen nur noch ein Auf- und/oder Abbiegen der Stanzbereiche erforderlich. Es ist vorteilhaft, daß der Stanz- und Biegeprozeß mit einem Werkzeug durchgeführt werden können.

Das erfindungsgemäße Luftverteilerblech für Lüftereinheiten oder Lüftereinschübe ist besonders wirkungsvoll bei Lüfteranordnungen mit Axiallüftern einzusetzen, welche wegen der integrierten Antriebsmotoren in der Regel einen relativ großen Nabenbereich aufweisen. Die Luftdurchtrittsöffnungen mit nach oben und/oder unten geneigten Stanzbereichen und Luftleitflächen können hierbei durch eine Richtungsänderung Teilluftsröme zu den Nabenbereichen lenken. Auf diese Weise werden "tote Bereiche" überbrückt bzw. eliminiert.

Es ist besonders zweckmäßig, ein Luftverteilerblech mit Öffnungen zu versehen, welche komplementär zu den Nabenbereichen der Lüfteranordnung ausgebildet sind und auf diese aufgelegt und nahezu selbstjustierend und/oder einrastend im Lüftereinschub angeordnet werden können.

Die Langlöcher als Luftdurchtrittsöffnungen sind zweckmäßigerweise derart angeordnet und dimensioniert, daß sie in Wirkverbindung mit den geneigten und die Luftleitflächen aufweisenden Stanzbereichen stehen, um eine erforderliche Luftverteilung und Luftströmung zu dem zu belüftenden Aufnahmeraum zu gewährleisten und Wärmenester zu vermeiden.

Besonders vorteilhaft sind Ausstanzungen bzw. Stanzbereiche, welche lamellenartig angestellt oder aber angekippt sind.

Bevorzugt sind die Stanzbereiche etwa rechteckig gestanzt. Unter angekippten Luftleitflächen sollen dabei Stanzungen verstanden werden, welche im Bereich einer Längsseite, gegebenenfalls auch über die gesamte Längsseite, abgewinkelt oder abgebogen werden können. Eine angekippte Stanzung mit einer Luftleitfläche kann somit entweder von der Unterseite oder von der Oberseite des Luftverteilerblechs abstehen. In Abhängigkeit von den zu belüftenden Objekten kann ein Luftverteilerblech sowohl nach unten als auch nach oben angekippte Stanzungen bzw. Luftleitflächen aufweisen.

Lamellenartig anstellbare Stanzungen mit zwei Luftleitflächen sind in bezug auf ihre Ausbildung und ihre Diffusorwirkung besonders vorteilhaft. Bei den Stanzungen für lamellenartige Luftleitflächen werden im Bereich der Kurzseiten der rechteckigen Ausstanzbereiche Verbindungsstege, welche zum Schräganstellen der Ausstanzungen und zur Ausbildung der Luftleitflächen verbogen bzw. verdreht werden, vorgesehen. Die seitlichen Verbindungsstege bilden somit eine Stell- oder Drehachse für die lamellenartigen Stanzungen. Deren Luftleitflächen stehen nach unten und nach oben über das Luftverteilerblech über.

Vorteilhafterweise kann durch eine mittige oder außermittige Anordnung der Verbindungsstege an den Kurzseiten der rechteckigen Stanzungen der Anteil der nach unten und nach oben gerichteten Luftleitflächen und damit deren Umlenkwirkung vorgegeben werden. In der Regel wird der Anteil der in Richtung Lüfter, d.h. nach unten gerichteten Luftleitflächen, größer sein, um eine Richtungsänderung des Luftvolumenstroms bereits unterhalb des Luftverteilerbleches zu erreichen, so daß die Luftdurchtrittsöffnungen ohne ankippbare oder anstellbare Luftleitflächen die angestrebte Verteilung des Luftvolumenstroms übernehmen können.

Zweckmäßigerweise sind die Stanzungen zur Ausbildung von Luftleitflächen wenigstens in Bereichen oberhalb der Luftaustrittsflächen der Einzellüfter ausgebildet. Für eine Richtungsänderung des Luftvolumenstroms eines Einzellüfters können z.B. vier rechteckige Stanzbereiche in Art eines Quadrats um die Öffnung im Nabenbereich angeordnet sein.

Zwischen den in Art eines Quadrates angeordneten rechteckigen Stanzungen für Luftleitflächen können radial ausgerichtete Langlöcher als Luftdurchtrittsöffnungen vorgesehen sein. Außerdem ist es zweckmäßig, radial außen noch weitere Stanzbereiche, vorzugsweise eckschrägenartig, anzuordnen und jalousieartig anzustellen, auf- oder abzubiegen.

Außerhalb der Luftaustrittsflächen der Lüfter, d.h. in den "Totbereichen", insbesondere zwischen den Lüftern und in Randbereichen sind vollständig ausgestanzte Luftdurchtrittsöffnungen, insbesondere Langlöcher, angeordnet.

Um individuelle Kühlungen zu ermöglichen, können die Langlöcher mit entsprechenden Elementen verschließbar oder abdeckbar ausgebildet werden. Alternativ können aufsteckbare Luftleitelemente vorgesehen sein.

Vorteilhafterweise können die ankippbaren oder lamellenartig anstellbaren Stanzbereiche nahezu eben oder leicht gebogen ausgebildet sein. Das Luftverteilerblech kann außerdem derart ausgebildet sein, daß der Biegeprozeß der Verbindungsstege und die Abwinklung eines Kippschenkels rückgängig gemacht werden können, um vor Ort ein verändertes Belüftungsprogramm realisieren zu können.

Fertigungstechnische Vorteile sind dadurch gegeben, daß die nahezu rechteckigen Stanzbereiche ohne spezielle Werkzeuge angekippt oder lamellenartig angestellt werden können. In einer besonders effizienten Fertigung kann der Stanzprozeß und der Biegeprozeß zum lamellenartigen Anstellen bzw. zum Ankippen in einem Werkzeug durchgeführt werden.

In einer Weiterbildung ist vorgesehen, daß die Luftleitflächen der angekippten und/oder lamellenartig angestellten Stanzbereiche durch zusätzliche Elemente vergrößert werden und/oder daß wenigstens eine Luftdurchtrittsöffnung der zwei durch lamellenartige Anstellung gebildeten Luftdurchtrittsöffnungen wenigstens teilweise abgedeckt oder verschlossen werden kann. Durch zusätzliche Elemente kann eine weitere Richtungsänderung eines Teilluftstroms erreicht werden. Bei Abdeckungen kann darüber hinaus die Kühlung definierter Geräte und Baugruppen oder Bauelemente gedrosselt werden.

Die wenigstens teilweise Abdeckung oder der partielle Verschluß von Durchtrittsöffnungen im Bereich der Luftleitflächen oder auch der schlitzartigen oder langlochartigen Luftdurchtrittsöffnungen kann in vielfältiger Weise erfolgen. Es sind rasterartig einklipsbare Abdeckelemente oder auch aufklebbare zusätzliche Elemente denkbar, welche bei Bedarf wieder entfernt werden können.

Wesentlich ist eine gezielte Richtungsänderung und Steuerung der Belüftung bei gleichzeitiger diffusorartiger Luftverteilung.

Bei Verwendung des erfindungsgemäßen Luftverteilerblechs in einem Geräteschrank oder LAN-Schrank besteht die Möglichkeit, dieses als Trennwand zwischen einem vertikalen oder horizontalen Luftkanal und dem Aufnahmeraum anzuordnen.

Beispielsweise kann ein vertikal angeordnetes Luftverteilerblech als eine Rückwand oder als wenigstens eine Seitenwand angeordnet werden. Ein Luftvolumenstrom kann von einem Lüfter oder einer Lüfteranordnung, von einem Gebläse oder von einer Druckluftleitung gebildet werden. Wenn beispielsweise zwischen einer Rückwand, in welcher eine Anordnung von Axiallüftern vorgesehen ist und einem Luftverteilerblech ein Lüftungskanal gebildet ist, können durch eine gezielte Ausbildung des Luftverteilerbleches Schrankbereiche mit unterschiedlicher Kühlwirkung oder auch Warmbereiche, geschaffen werden.

In einer weiteren Ausgestaltung ist vorgesehen, oberhalb eines Luftverteilerblechs bzw. zwischen einem Luftverteilerblech und den zu kühlenden Objekten einen weiteren Diffusor anzuordnen. Dieser weitere Luftverteiler kann beispielsweise als ein Lochblech ausgebildet werden. Bevorzugt sind Ausstanzungen über die gesamte Fläche des weiteren Luftverteilers ausgebildet. Dieser weitere Luftverteiler dient insbesondere einer Vergleichmäßigung wenigstens einer Luftwelle, welche im ersten Luftverteilerblech durch Richtungsänderung gebildet wird. Es kann eine Abschwächung der verstärkten Teilluftströme und/oder eine weitere Verwirbelung erreicht werden.

Die Erfindung wird nachstehend anhand einer Zeichnung weiter erläutert; in dieser zeigen in einer stark schematisierten Darstellung
- Fig. 1: eine Draufsicht auf ein erfindungsgemäßes Luftverteilerblech für einen Lüftereinschub mit drei Axiallüftern;
- Fig. 2: einen Vertikalschnitt eines lamellenartig angestellten Stanzbereichs nach Linie II-II gem. Fig. 1;
- Fig. 3: eine Ansicht eines lamellenartig angestellten Stanzbereichs nach Pfeil III gem. Figur 1 und 2;
- Fig. 4: einen Vertikalschnitt eines lamellenartig angestellten Stanzbereichs nach Linie IV-IV gem. Fig.1;
- Fig. 5: eine Ansicht eines lamellenartig angestellten Stanzbereichs nach Pfeil V gem. Figur 1 und 4;
- Fig. 6: eine durch Ankippen einer Stanzung gebildete Luftleitfläche und
- Fig. 7: einen Vertikalschnitt eines lamellenartig angestellten Stanzbereichs mit Abdeckung nach Linie VI-VI gem. Fig.1.

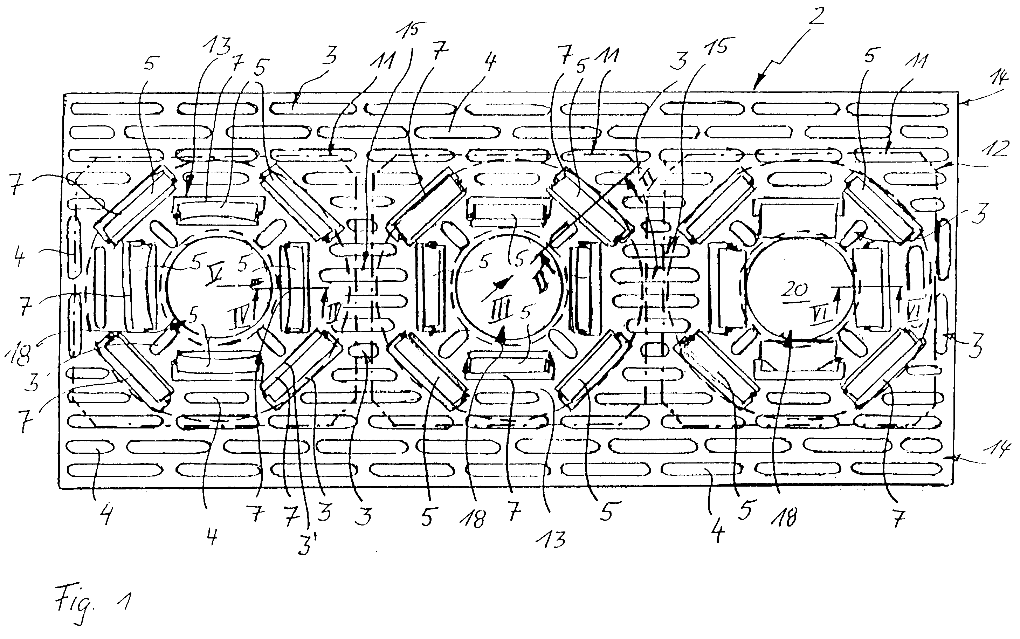

In Figur 1 ist ein Luftverteilerblech 2 dargestellt, welches für einen Lüftereinschub mit jeweils drei nebeneinander angeordneten Axiallüftern 11 vorgesehen ist. Derartige Lüftereinschübe haben den Vorteil einer relativ niedrigen Bauweise. Die Axiallüfter erzeugen einen mittleren Volumenstrom, einen mittleren Druck und sind relativ leise. Bei bisher bekannten Lüftereinschüben tritt ein Volumenstrom nur im Bereich einer Austrittsfläche 13 aus, so daß nur die in diesem Bereich eines Aufnahmeraums (nicht dargestellt) angeordneten elektrischen und elektronischen Geräte, Baugruppen etc. gekühlt werden.

Das Luftverteilerblech 2 ist derart dimensioniert, daß die gesamte Fläche eines Lüftereinschubs und einer komplementären Lufteintrittsfläche des Aufnahmeraums (nicht dargestellt) abgedeckt wird.

Das Luftverteilerblech 2 ist aus einem Flach- bzw. Plattenmaterial, z.B. einem Stahlblech mit einer Stärke von etwa 1,5 mm, gefertigt und weist über die gesamte Oberfläche Luftdurchtrittsöffnungen 3 auf, welche als Ausstanzungen und in diesem Beispiel als Langlöcher 4 ausgebildet sind. Außerdem sind Luftdurchtrittsöffnungen 3, 3' ein- oder beidseitig von Stanzungen bzw. Stanzbereichen 7 gebildet, wenn diese nach oder bereits während des Stanzvorgangs schräg gestellt werden. Es sind alternative Ausbildungen der langloch- oder auch schlitzartigen Luftdurchtrittsöffnungen 3 möglich.

In Draufsicht kreisringförmige Luftaustrittsflächen 13 der Axiallüfter 11 sind mit strichlierten Linien dargestellt. Die Umrisse der Axiallüfter 11 unterhalb des Luftverteilers 2 sind mit strichpunktierten Linien dargestellt.

Fig. 1 verdeutlicht, daß das Luftverteilerblech 2 mit einem System von Ausstanzungen 4 und Stanzungen 7 für die Luftdurchtrittsöffnungen 3 und Luftleitflächen 5 versehen ist und daß die Ausstanzungen 4 und Stanzungen 7 in einem derartigen Muster ausgebildet und angeordnet sind, daß ein Luftvolumenstrom wenigstens teilweise einer Richtungsänderung unterworfen und verteilt, verstärkt oder auch abgeschwächt werden kann.

Wesentlich für die Richtungsänderung und Diffusorwirkung des Luftverteilerblechs 2 sind die Stanzungen 7 im Bereich der Luftaustrittsflächen 13. Diese Stanzungen 7 sind etwa rechteckig ausgebildet und können über Verbindungsstege 8 an den Kurzseiten mit einem auswählbaren Neigungswinkel lamellenartig angestellt werden. Dadurch werden Luftleitflächen wirksam, welche Teilluftströme in "Totbereiche" umlenken.

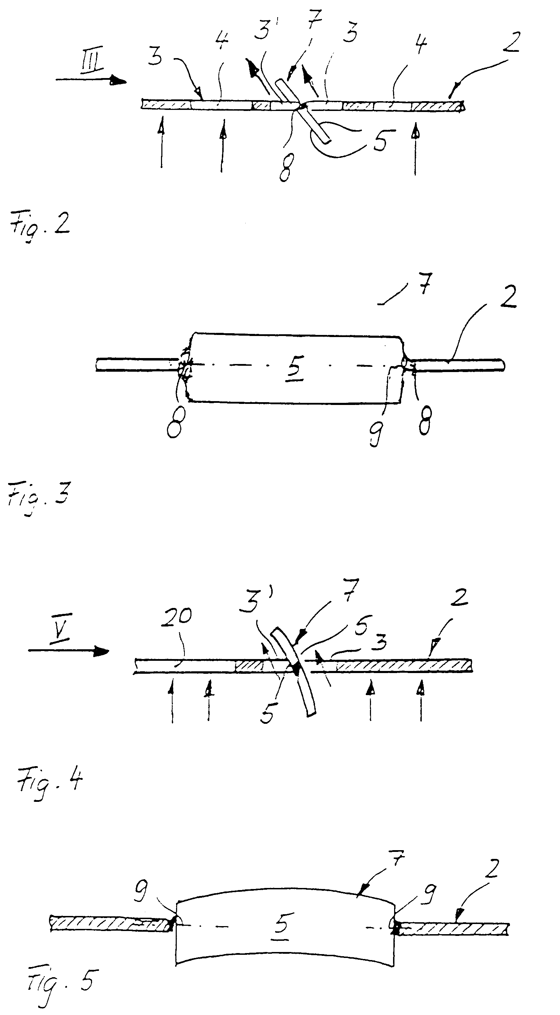

Lamellenartig angestellte bzw. schräg angeordnete Stanzbereiche 7 gehen aus den Figuren 2 bis 5 hervor. Alternativ können auch abgewinkelte oder angekippte Stanzungen 7 ausgebildet sein (siehe Fig. 6).

Die Lüftereinheit 12, welche in Figur 1 aus drei Einzellüftern 11 gebildet wird, ist mit dem Luftverteilerblech 2 abgedeckt, welches damit gleichzeitig als Schutz gegen ein unbeabsichtigtes Eingreifen in die Lüfterräder (nicht dargestellt) dient. Besonders vorteilhaft ist die unkomplizierte Anordnung durch eine Auflage in den Nabenbereichen 18 der Lüfter 11.

Zu diesem Zweck sind komplementäre Öffnungen 20 im Luftverteilerblech 2 ausgebildet. Koaxial zu diesen Öffnungen 20 sind rechteckige Stanzungen 7 in Art eines Quadrates ausgebildet, welche im Ausführungsbeispiel nach Fig. 1 lamellenartig angestellt sind. In Eckbereichen des Quadrats sind radial angeordnete Langlöcher 4 ausgebildet und nach radial außen schließen sich, eckschrägenartig angeordnet, weitere Stanzungen 7 an. Diese sind derart angestellt, daß Randbereiche 14 und/oder Zwischenbereiche 15 des Luftverteilers 2 bzw. des Aufnahmeraums belüftet werden. Die innen und in Art eines Quadrates angestellten Stanzungen 7 mit Luftleitflächen 5 sind derart angestellt, daß Teilluftströme zum Nabenbereich 18 gelenkt werden.

In den Figuren 2 bis 5 sind mögliche Ausbildungen von lamellenartig angestellten Stanzungen 7 dargestellt. Durch die Schrägstellung der Stanzung 7 sind zwei Luftdurchtrittsöffnungen 3, 3' gebildet (Fig. 2). Die Richtung der Teilluftströme, welche durch Pfeile gezeigt ist, wird durch den Neigungswinkel der Stanzung 7 bestimmt und ist vorgebbar. Die Stanzung gemäß Fig. 2 weist Verbindungsstege 8 auf, welche außermittig an den Kurzseiten der Stanzung 7 angeordnet sind, so daß ein größerer Anteil der Luftleitflächen 5 der Stanzung 7 an der Unterseite des Luftleitblechs 2 übersteht und wirksam wird.

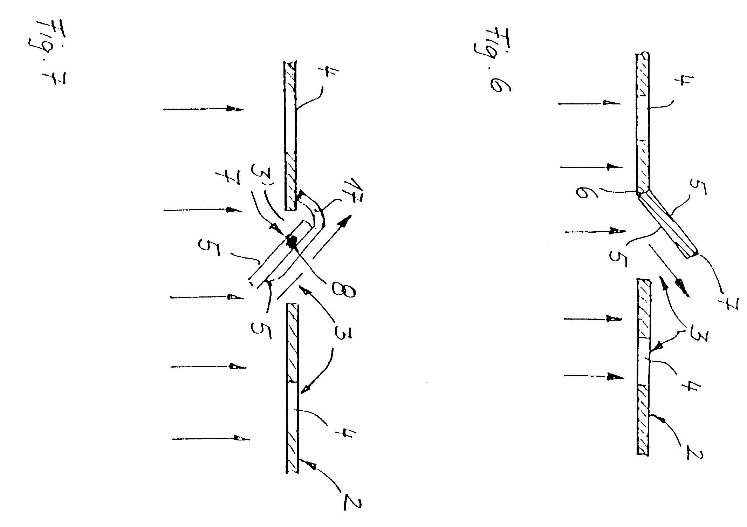

Figur 3 verdeutlicht, daß die Luftleitflächen 5 der Stanzung 7 nach Figur 2 eben ausgebildet sind. Gleiche Merkmale der Figuren sind mit identischen Bezugszeichen versehen.

Eine alternative Ausbildung der lamellenartig angestellen Stanzungen 7 ist in den Figuren 4 und 5 dargestellt. Der Unterschied zu den Stanzungen 7 nach Fig. 2 und 3 besteht in einer leicht gebogenen Ausbildung der Stanzung und damit der Luftleitflächen 5. Um eine Umlenkung des Luftvolumenstroms über Bereiche zu erreichen, welche außerhalb der Luftaustrittsfläche 13 eines Axiallüfters 11 liegen, sind die bogenförmig ausgebildeten Stanzbereiche 7 derart ausgestanzt, daß ein grösserer Bereich der Luftleitflächen 5 von der Unterseite des Luftverteilerbleches 12 in Richtung Axiallüfter (nicht dargestellt) ragt. Die Umlenkung des Luftvolumenstromes durch die Luftleitflächen 5 ist wiederum durch Pfeile dargestellt. Unter Bezugnahme auf Fig. 1 wird deutlich, daß durch derartig ausgebildete und angestellte Stanzungen 7 ein Bereich oberhalb der Naben 18 mit Kühlluft versorgt werden kann.

Eine weiter alternative Ausbildung von Luftleitflächen 5 geht aus Fig. 6 hervor. Ein nahezu rechteckiger Stanzbereich 7 ist über eine Kippachse 6 im Bereich einer Längsseite der Stanzung 7 aufgebogen. Die Stanzung 7 kann nach unten oder nach oben abgebogen werden, je nach dem, in welche Richtung ein Teilluftstrom (siehe Pfeil) geleitet werden soll. Durch angekippte oder auch abgewinkelte Stanzungen 7 wird eine Luftdurchtrittsöffnung 3 gebildet.

Die lamellenartig angestellten oder angekippten Stanzungen 7 können gegebenenfalls wieder flachgedrückt und nahezu wieder rückgängig gemacht werden können, falls dies, beispielsweise bei einer veränderten Bestückung eines Aufnahmeraums, erforderlich werden sollte.

Fig. 7 zeigt eine lamellenartig angestellte Stanzung 7, welche zunächst zwei Luftdurchtrittsöffnungen 3, 3' und Luftleitflächen 5 aufweist. Um eine weitere Möglichkeit für eine Beeinflussung eines Luftvolumenstroms, insbesondere eines Lüftereinschubs zu schaffen, ist ein zusätzliches Element 17 derart angeordnet, daß eine Luftdurchtrittsöffnung 3 wenigstens teilweise abgedeckt bzw. verschlossen wird. Ein derartiges Abdecken oder Verschließen einer der zwei Luftdurchtrittsöffnungen 3, 3' sorgt für eine lokale Drosselung und eine veränderte Verteilung der Teilluftströme durch die in einem Stanzvorgang, mit oder ohne Luftleitflächen 5 ausgebildeten Luftdurchtrittsöffnungen 3, 3'.

## Patentansprüche

1. Anordnung zur Belüftung von elektrischen und elektronischen Geräten, Baugruppen und Bauelementen, welche in einem Aufnahmeraum von Gehäusen, Schränken und Baugruppenträgern und Behältern angeordnet sind, mit einem Luftverteilerblech (2), welches vor den zu belüftenden elektrischen und elektronischen Geräten, Baugruppen und Bauelementen angeordnet und mit Luftdurchtrittsöffnungen (3) und Luftleitflächen (5) versehen ist,
dadurch **gekennzeichnet**,
daß das Luftverteilerblech (2) nahezu die gesamte Fläche einer Lüftereinheit (12) mit Axiallüftern (11) abdeckt und auf oder an den Axiallüftern (11) angeordnet ist und
daß die Luftdurchtrittsöffnungen (3) und Luftleitflächen (5) der Ausbildung und Anordnung der Axiallüfter (11) und den zu belüftenden Geräten, Baugruppen und Bauelementen entsprechend angeordnet sind.

2. Anordnung nach Anspruch 1,
dadurch **gekennzeichnet**,
daß das Luftverteilerblech (2) oberhalb der Lüftereinheit (12) aus Axiallüftern (11) angeordnet und mit einem System von Ausstanzungen (4) und Stanzungen (7) für die Luftdurchtrittsöffnungen (3) und Luftleitflächen (5), welches der Ausbildung der Luftaustrittsflächen (13) der Axiallüfter angepaßt ist, versehen ist.

3. Anordnung nach Anspruch 2,
dadurch **gekennzeichnet**,
daß das Luftverteilerblech (2) jeweils im Bereich einer Nabe (18) eines Axiallüfters (11) eine Öffnung (20) aufweist und daß im Bereich der Luftaustrittsfläche (13), welche kreisringförmig ausgebildet ist, lamellenartig anstellbare und/oder ankippbare Stanzungen (7) mit den Luftleitflächen (5) und den Durchtrittsöffnungen (3, 3') als Quadrat und eckschrägenartig angeordnet sind.

4. Anordnung nach Anspruch 3,
dadurch **gekennzeichnet**,
daß das Luftverteilerblech (2) zwischen den lamellenartig anstellbaren oder ankippbaren Stanzungen (7) im Bereich der Luftaustrittsflächen (13) der einzelnen Axiallüfter (11) sowie in Randbereichen (14) und zwischen den Luftaustrittsflächen (13) Langlöcher (4) als Luftdurchtrittsöffnungen (3) aufweist.

5. Anordnung nach Anspruch 1,
dadurch **gekennzeichnet**,
daß das Luftverteilerblech (2) ein Flach- oder Plattenmaterial ist und die Luftdurchtrittsöffnungen (3) durch einen Stanzvorgang und die Luftleitflächen (5) gleichzeitig oder nach dem Stanzvorgang durch einen Biegevorgang einbringbar sind.

6. Anordnung nach Anspruch 5,
dadurch **gekennzeichnet**,
daß das Luftverteilerblech (2) ein Stahlblech oder ein Flach- oder Plattenmaterial aus einem nichtmetallischen Werkstoff ist, die Luftdurchtrittsöffnungen (3) als Langlöcher (4) ausstanzbar und die Luftleitflächen (5) lamellenartig angestellte, angekippte oder abgewinkelte Stanzungen (7) sind und die Luftleitflächen (5) eben oder bogenförmig ausgebildet sind.

7. Anordnung nach Anspruch 6,
dadurch **gekennzeichnet**,
daß die Stanzungen (7) beim lamellenartigen Anstellen an beiden Seiten über das Flach- bzw. Plattenmaterial (2) überstehen und zwei Luftdurchtrittsöffnungen (3, 3') für Teilluftströme gebildet sind und daß beim Ankippen oder Abwinkeln einer Stanzung (7) die Luftleitfläche (5) und Luftdurchtrittsöffnung (3) gebildet sind.

8. Anordnung nach Anspruch 7,
dadurch **gekennzeichnet**,
daß die Stanzungen (7) für die Luftleitflächen (5) nahezu rechteckig ausgebildet sind und Verbindungsstege (8) aufweisen, welche eine Stellachse (9) für die lamellenartig anstellbaren Ausstanzungen (7) bilden, und daß die ankippbaren Stanzungen (7) an einer Kippachse (6) nach unten oder oben gebogen sind.

9. Anordnung nach Anspruch 7,
dadurch **gekennzeichnet**,
daß wenigstens eine der zwei Durchtrittsöffnungen (3, 3') durch zusätzliche Elemente (17) der lamellenartig angestellten Stanzungen (7) wenigstens teilweise abgedeckt oder verschlossen ist und daß die Größe der Luftleitflächen (5) der angestellten Stanzungen (7) durch die zusätzlichen Elemente (17) veränderbar ist.

10. Anordnung nach Anspruch 8,
dadurch **gekennzeichnet**,
daß die Stanzungen (7) durch einen Biegeprozeß der Verbindungsstege (8) lamellenartig anstellbar und mit Hilfe eines Werkzeugs und in einem Arbeitsgang mit dem Stanzprozeß lamellenartig anstellbar, ankippbar oder abwinkelbar sind.

11. Anordnung nach Anspruch 1,
dadurch **gekennzeichnet**,
daß zwischen dem Luftverteilerblech (2) und den zu belüftenden elektrischen und elektronischen Geräten, Baugruppen und Bauelementen ein weiterer Luftverteiler angeordnet ist, welcher insbesondere als ein Lochblech ausgebildet ist.

12. Anordnung nach Anspruch 1,
dadurch **gekennzeichnet**,
daß der Luftverteiler (2) im Luftvolumenstrom eines Gebläses oder eines Lüfters oder einer Lüftereinheit angeordnet ist, welcher einem Geräteschrank und den darin aufgenommenen Geräten, Baugruppen und Bauelementen zugeführt ist, und daß die Ausstanzungen (4) und Stanzungen (7) für die Luftdurchtrittsöffnungen (3, 3') und Luftleitflächen (5) entsprechend den jeweils erforderlichen Belüftungen ausgebildet sind.
